Europäisches Patentamt

(19) European Patent Office

Office européen des brevets

(11) Publication number: **0 134 623**
**B1**

(12) **EUROPEAN PATENT SPECIFICATION**

(45) Date of publication of patent specification: **10.08.88**

(51) Int. Cl.⁴: **H 01 L 23/48**, H 01 L 21/68

(21) Application number: **84303778.9**

(22) Date of filing: **05.06.84**

(54) **Electrically and thermally conductive adhesive transfer tape.**

(30) Priority: **13.06.83 US 503578**

(43) Date of publication of application:
**20.03.85 Bulletin 85/12**

(45) Publication of the grant of the patent:
**10.08.88 Bulletin 88/32**

(84) Designated Contracting States:
**AT BE CH DE FR GB IT LI NL SE**

(56) References cited:
DE-A-3 414 961
US-A-3 896 544
US-A-4 285 433
PATENTS ABSTRACTS OF JAPAN, vol. 7, no.
99 (E-172)1244r, 27th April 1983; & JP - A - 58
21 350 (SUWA SEIKOSHA K.K.) 08-02-1983
PATENTS ABSTRACTS OF JAPAN, vol. 6, no.
144 (E-122)1022r, 3rd August 1982; & JP - A - 57
68 053 (SUWA SEIKOSHA K.K.) 26-04-1982
PATENTS ABSTRACTS OF JAPAN, vol. 7, no.
58 (E-163)1203r, 10th March 1983; & JP - A - 57
204 138 (HITACHI SEISAKUSHO K.K.) 14-12-
1982

(73) Proprietor: **MINNESOTA MINING AND
MANUFACTURING COMPANY**
**3M Center, P.O. Box 33427**
**St. Paul, Minnesota 55133-3427 (US)**

(72) Inventor: **Reylek, Robert S. Minnesota Mining
and**
**Manufacturing Company 2501 Hudson Road**
**P.O. Box 33427 St. Paul Minnesota 55133 (US)**
Inventor: **Thompson, Kenneth C. Minnesota
Mining and**
**Manufacturing Company 2501 Hudson Road**
**P.O. Box 33427 St. Paul Minnesota 55133 (US)**

(74) Representative: **Baillie, Iain Cameron et al**
**c/o Ladas & Parry Isartorplatz 5**
**D-8000 München 2 (DE)**

Courier Press, Leamington Spa, England.

**0 134 623**

(56) References cited:
PATENTS ABSTRACTS OF JAPAN, vol. 6, no.
247 (E-146)1125r, 7th December 1982; & JP - A -
57 145 339 (OKI DENKI KOGYO K.K.) 08-09-1982
PATENTS ABSTRACTS OF JAPAN, vol. 8, no.
123 (E-249)1560r, 8th June 1984; & JP - A - 59
35 434 (NIPPON DENKI K.K.) 27-02-1984
PATENTS ABSTRACTS OF JAPAN, vol. 8, no.
44 (E-229)1481r, 25th February 1984; & JP - A -
58 199 529 (HITACHI SEISAKUSHO K.K.) 19-11-
1983

## Description

### Field of the invention

The invention concerns an adhesive transfer tape which makes electrically and thermally conductive bonds such as are desirable for attaching a semiconductor die or chip to an electrically and thermally conductive substrate, a use previously served primarily by spreadable adhesives or by strips or solder or eutectic alloy.

### Background art

Semiconductors such as integrated circuits are formed on wafers which are then cut into dice or chips that individually may be mounted onto substrates. Usually the substrate is electrically and thermally conductive, and mounting provides both good electrical and good thermal conductivity between the die and the substrate. Good thermal conductivity permits the substrate to serve as a heat sink for the die. An effective heat sink is desirable, because as a rule of thumb, an increase of 10°C in the operating temperature of a semiconductor die reduces its life by one-half. Generally the attainment of good thermal conductivity is inherently accompanied by adequate electrical conductivity.

Of the two prevalent techniques for attaching a semiconductor die to an electrically and thermally conductive substrate, one employs a solder or eutectic alloys such as a gold-silicon alloy. While such alloys provide excellent electrical and thermal conductivity, they are exceedingly expensive. Also, their application temperatures may be so high that some dice might be damaged, and differences in thermal expansion sometimes cause a die to break. Furthermore, it is difficult to handle an individual die together with an alloy strip or the same size.

Because of the expense and difficulties in using eutectic alloys, it has become more common to employ a spreadable die attach adhesive consisting of a heat-curing epoxy resin composition filled with fine metal particles, usually silver and occasionally gold (see, e.g. Patent Abstracts of Japan, Vol. 7, No. 99 (E-172) [1244], 27th April 1983). Spreadable epoxy adhesives can be difficult to use, especially those which are marketed in two parts and must be thoroughly mixed shortly before use. Care must be taken to keep the metal particles in suspension, to spread out a uniform layer of the proper thickness, and not to allow voids in the adhesive layer. Automated attachment of dice to substrates is complicated by the waiting period during which the epoxy composition is cured.

### Disclosure of the invention

The above-discussed difficulties of prior die attach systems are avoided in the present invention by an electrically and thermally conductive adhesive transfer tape which is easy to use and reliably attaches individual semiconductor dice to conductive substrates. As compared to metal-filled epoxy compositions, the novel adhesive transfer tape should be of comparable cost.

Briefly, the adhesive transfer tape of the invention comprises a flexible, low-adhesion carrier web to which is lightly adhered a layer of adhesive containing electrically and thermally conductive particles which at the bonding temperature of the adhesive are at least as deformable as are substantially pure silver spherical particles at ordinary room temperature. The particles should be of uniform thickness. By "uniform" is meant that substantially all of the particles (disregarding fines, which are too difficult to eliminate) differ in diameters by no more than 2 to 1. The average thickness of the particles is greater than the thickness of the adhesive between particles, preferably from 10 to 100% greater. The particles are uniformly distributed throughout the layer or throughout preselected segments of the layer. When the particle-containing adhesive layer is removed from the carrier web and compressed between two flat, rigid plates, the particles are flattened to the thickness of the adhesive between particles. This provides small, flat conductive areas at both surfaces of the adhesive layer sufficient to provide good electrical and thermal contact between a die and a conductive substrate through each of the flattened particles.

While being primarily useful as a die attach adhesive tape, the novel transfer tape can be used wherever it is desired to make an electrically conductive bond between two rigid, uniformly spaced surfaces. Although such uses may not require good thermal conductivity, this inherently is achieved due to the direct contact of each of the electrically and thermally conductive particles to each of the surfaces which are being bonded together. In one such use, the novel tape can be used for surface-mounted components of a printed circuit board. For example, a chip carrier having a plurality of conductive pads can be bonded by the novel transfer tape to connect each pad individually to a conductor in the printed circuit board. The adhesive layer of the novel tape provides good electrical conductivity through its thickness and good electrical insulation laterally, especially when the particles occupy less than 40% by volume of the adhesive layer.

To economize the use of the electrically conductive particles, they may be located only in segments of the novel adhesive transfer tape which are to contact individual electrical conductors. This can be accomplished by the steps of:

1) coating onto a flexible, low-adhesion carrier web a viscous monomer composition which is radiation-polymerizable to an adhesive state,

2) selectively exposing the coating to radiation to polymerize segments of the monomer composition to a substantially tack-free adhesive state,

3) applying electrically conductive particles to the coating to become adhered only to the viscous monomer composition, and

4) again exposing the coating to radiation to polymerize the balance of the coating to a substantially tack-free adhesive state.

Because the viscosity of a mixture of polymerizable monomers may be too low to provide desirably thin coatings, the monomers may be partially polymerized to provide a sufficiently viscous monomer composition, e.g., having a coatable viscosity within the range of 1000 to 40,000 cps.

A second technique for locating electrically conductive particles only in preselected segments of the adhesive layer involves the steps of:

1) coating onto a flexible, low-adhesion carrier web a viscous monomer composition which is radiation-polymerizable to an adhesive state and contains electrically conductive particles,

2) selectively exposing the coating to radiation to polymerize segments of the monomer composition to a solvent-resistant adhesive state,

3) dissolving or otherwise removing portions of the coating between the polymerized adhesive segments, and

4) overcoating the entire segment-containing face of the carrier web with an adhesive such that the total thickness of both adhesive layers between particles is less than the average thickness of the particles.

The adhesive applied in step 4) can be applied from solution or as a radiation-polymerizable monomer composition.

A third technique is similar to the second except that instead of steps 1) and 2), an adhesive is applied from solution only onto preselected segments of the low-adhesion carrier, e.g., by silk screening.

Preferably the adhesive of the novel transfer tape is heat-activatable, i.e., a thermosetting, hotmelt or hot-tackifying adhesive. Such adhesives usually are nontacky at ordinary room temperatures and, upon being activated by heat, flow sufficiently under pressure such that the faces of the small, flat conductive areas created at the surfaces of the adhesive layer should be free from adhesive.

When the novel transfer tape has a heat-activatable adhesive, its low-adhesion carrier web preferably has sufficient resistance to heat to permit the adhesive to be heat-activated while being supported by the carrier web. Particularly useful carrier webs are polytetrafluoroethylene and polyimide films, both of which have good heat resistance, strength, dimensional stability, and age resistance. Also useful are biaxially-oriented polyethylene terephthalate, aromatic polyimide ("Kevlar"), and polyvinyl fluoride ("Tedlar") films.

The adhesive layer of the novel adhesive transfer tape preferably is a polymer of alkyl acrylate and/or methacrylate having an average of 1—12 carbon atoms in the alkyl groups. Such a polymer provides better adhesion when it is a copolymer of monomers, up to 50 mol% of which is at least one copolymerizable monomer selected from acrylic acid, methacrylic acid, itaconic acid, maleic acid, maleic anhydride, amides of said acids, and N-vinyl-2-pyrrolidone. The acids should be minimized or avoided when electrical connections are to be made where corrosion might be a problem. Polymers based on alkyl acrylates having an average of 4—12 carbon atoms in their alkyl groups are pressure-sensitive adhesives and may have a weight-averaged Tg in the range from −20° to −70°C. When the average is 1—3 or when a polymer is based on an alkyl methacrylate, the copolymer may have a weight-averaged Tg in the range from −10° to −80°C and be nontacky or poorly tacky at ordinary room temperatures, but become agressively tacky when heated. An adhesive which is nontacky at ordinary room temperatures better holds electrically-conductive particles in place after the novel tape has been applied to make electrical connections. Hence, those electrical connections tend to be more secure and more resistant to brief exposure to soldering temperatures. Where such exposure is contemplated, a weight-averaged $T_g$ of from 30° to 80°C is preferred. However, much the same result can be attained by crosslinking a polymer of lower $T_g$ after the electrical connections have been made, e.g., as taught in U.S. Patent No. 2,925,174.

The particles of the novel tape preferably are substantially spherical, a shape readily deformable to the thickness of the adhesive between particles. Preflattened particles such as those of U.S. Patent No. 3,514,326 (Stow) can also be used but should be made of softer materials because pre-flattened particles have more resistant to further flattening. When pre-flattened particles are further flattened, there is a hazard of trapping adhesive between the area's particles and the surface against which they are further flattened.

Whether pre-flattened or spherical, the particles preferably are made of a metal such as silver or gold or of laminated metals, one of which preferably is at least as deformable at the bonding temperature of the adhesive as is substantially pure silver at ordinary room tempertures. When a transfer tape of the invention has a heat-activatible adhesive, its particles may be laminates of materials, one of which melts at the activation temperature of the adhesive. Such a laminated particle may have a surface layer that melts and a core that does not melt at the activation temperature of the adhesive, for example, a solder surface layer and either a higher melting metal core such as copper or a nonmetallic core. Another useful laminated particle has a surface layer that does not melt and a core that melts at the activation temperature of the adhesive. The core of such a particle may be a solder, and its surface layer may be a higher melting metal such as silver or copper.

·Each of the particles of the novel tape may be an aggregate of tiny fused granules such as granules of a metal which is at least as deformable as substantially pure silver.

Because the heat-activatable adhesive of the novel tape preferably is nontacky at ordinary ambient temperatures, the adhesive layer could be wound directly upon itself for storage and shipment. Since it is necessary to form the adhesive layer on a low-adhesion carrier web, it is convenient to wind the two together for storage and shipment.

A preferred range of thicknesses for the adhesive between particles is from 0.01 to 0.05 mm, and the average particle thickness is preferably between 20 and 80% greater than the adhesive thickness between particles. When the particles have highly uniform thicknesses, excellent results are attained at an average particle diameter only 5% greater than the adhesive thickness between particles.

When the particles comprise 5% by volume of the adheisve layer and their average thickness is one-third greater than the adhesive layer between particles, the average spacing between adjacent particles is about 0.13 mm when the adhesive thickness between particles is 0.02 mm. The average spacing may be as great as about 0.5 mm and preferably is within the range of 0.05 to 0.3 mm in order to insure a good overall electrical and thermal conductivity.

While the novel tape preferably contains electrically and thermally conductive particles, equivalent results can be attained by substituting for the particles other electrically and thermally conductive elements which are as deformable as are the particles under the same conditions to provide small, flat conductive areas at both surfaces of the adhesive layer. For example, the electrically and thermally conductive elements may together form a metal foil, the thickness of which is less than that of the adhesive by itself, but which has at each surface of the layer protuberances that are closely spaced and uniformly distributed throughout the layer. The average distance between apices of the protuberances at one surface to those at the other surface should be greater than, perferably from 10% to 100% greater than, the thickness of the adhesive between protuberances. The protuberances may be provided by embossing the foil as in U.S. Patent No. 3,497,383 (Olyphant) to form ridges at the surfaces of the adhesive layer that are flattened to provide narrow, elongated flat areas when the adhesive layer is compressed between two flat, rigid plates. Each upstanding portion of metal foil extending between an elongated flat area in one surface and the closest flat area in the other surface provides a metal element that conducts heat and electricity across the adhesive layer. Alternatively, a metal foil may have additional metal fused to its surfaces. For example, drops of silver or of a solder may be fused to a copper foil to provide protuberances, each of which is sufficiently soft to be flattened when the adhesive layer is compressed between two flat, rigid plates.

The metal foil may have uniformly distributed perforations, in which event the adhesive layer of the novel tape may be continuous. When the metal foil is imperforate, the adhesive layer necessarily is separated by the foil into two laminae.

Useful electrically and thermally conductive elements of the novel tape can also be provided by a wire screen of a conductive material which at the bonding temperature of the adhesive preferably is at least as deformable as is substantially pure silver at ordinary room temperature. The pressure applied to such a screen would not only provide small, flat areas on the wires at the surfaces of the adhesive layer but would also flatten the wires at their crossing points, thus enhancing the conductivity of the direct paths between the flattened surface areas.

The novel adhesive transfer tape may be used as a die attach adhesive as follows. First, the tape is adhered by its heat-activated adhesive layer to the back surface of an undiced semiconductor wafer. The wafer is then diced while the carrier web serves the function for which wafer sawing films are currently used. Each resulting die has its own conductive adhesive layer by which it may be bonded to a conductive substrate after removal of the carrier web. If desired, the adhesive-bearing die may be stored indefinitely at room temperature before being adhesively attached to a substrate.

Preferably the novel adhesive tape is used in connection with a conventional wafer sawing film. After bonding the tape by its own heat-activated adhesive tape to a semiconductor wafer and allowing the adhesive to cool, the carrier web is stripped away, and the exposed adhesive layer is adhered to the wafer sawing film by the low-tack adhesive of the wafer sawing film. Then while the wafer sawing film is stretched in a hoop fixture, the wafer and adhesive are diced. Care should be taken in selecting the wafer sawing film that its low-tack adhesive does not contaminate the adhesive of the novel tape.

The adhesive layer of the novel tape may be transferred onto an adhesiveless backing of a wafer sawing film which has a low-adhesion surface. A semiconductor wafer may be bonded by the adhesive layer to the wafer sawing film and sawed into dice, each thus immediately having an electrically and thermally conductive adhesive layer.

Brief descrition of the drawings

In the drawings:

Figure 1 is a schematic transverse cross-section of a die attach adhesive tape of the invention;

Figure 2 is a schematic transverse cross-section showing a semiconductor wafer to which the tape of Figure 1 has been adhered and in turn mounted on a wafer sawing film for dicing; and

Figure 3 shows the use of an adhesive tape similar to that of Figures 1 and 2 being used to attach a semiconductor die to a conductive substrate.

Detailed description

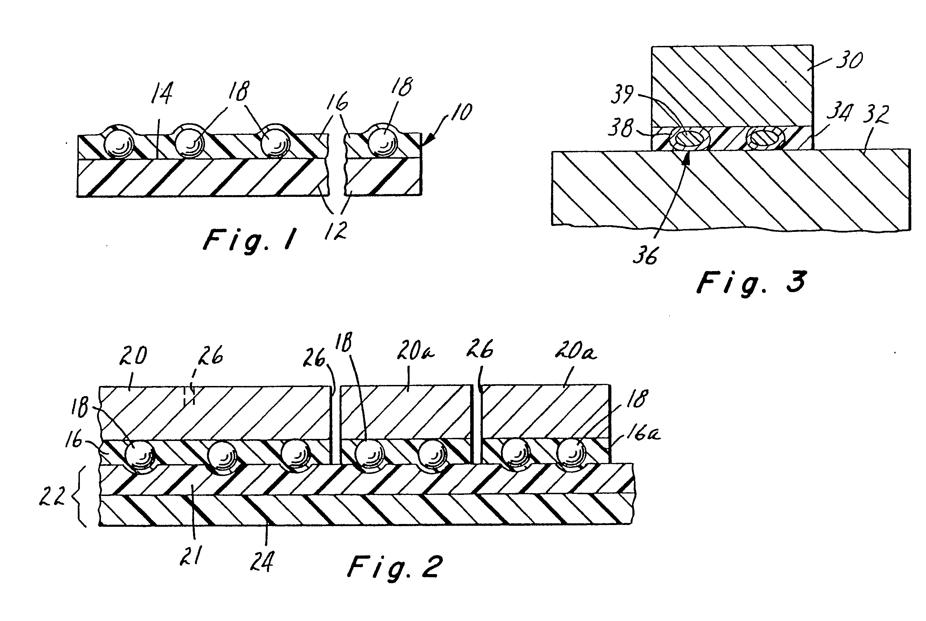

The adhesive tape 10 of Fig. 1 has a flexible carrier web 12 having a low-adhesion surface 14 to which is lightly adhered a layer of adhesive 16 containing spherical electrically and thermally conductive metal particles 18, the diameters of which exceed the thickness of the adhesive 16 between particles.

In Fig. 2, a piece of tape 10 has been adhered by its layer of adhesive 16 to a semiconductor wafer 20 and the carrier web 12 has been stripped off and discarded. The exposed layer of adhesive 16 has been pressed against the low-tack adhesive layer 21 of a conventional wafer sawing film 22 having a carrier web 24. While the wafer sawing film is stretched across a hoop fixture (not shown), the wafer 20 and the adhesive layer 16 are sawed at 26. Because the adhesive bond between the low-tack adhesive layer 21 and the carrier web 24 is stronger than the bond between the two adhesive layers, each die 20a and its adhesive layer 16a can be lifted off the wafer sawing film 22 and adhesively bonded to a conductive substrate to provide a composite similar to that illustrated in Fig. 3.

Figure 3 shows a die 30 which is bonded to an electrically and thermally conductive substrate 32 by a layer of heat-activated adhesive 34 containing electrically and thermally conductive laminated particles 36. Each of those particles has been flattened by pressing the die 30 against the substrate 32, and that part of the adhesive 34 which had covered the particles has been forced out from between the particles and the substrate 32, thus providing small, flat conductive areas at each surface of the layer of adhesive 34. Each particle 36 has a core 39 and a surface layer 38, one of which may have melted while the other did not melt at the temperature at which the adhesive 34 was activated.

In the following examples, all parts are given by weight unless otherwise noted.

Example 1

An acrylic polymer was made by mixing together 15.5 parts ethyl acrylate, 15.5 parts methyl acrylate, 1.65 parts acrylamide, 0.3 part gamma-methacryloxypropyltrimethoxysilane, 67 parts ethyl acetate and 0.1 part azo-*bis*-isobutyl-nitrile ("Vazo" 64 catalyst), purging the mixture with nitrogen to remove oxygen, and heating at 53—55°C for 16 hours to give 98—99% conversion to polymer. Weight-averaged $T_g$ of this polymer was 60°C. To this was added 16.5 parts of spherical silver particles which had been sieved, selecting particles which passed through a 400-mesh Tyler sieve (38-micrometer openings) and which were held on a 500-mesh sieve (25-micrometer openings). This combination was then knife-coated onto a film of polytetrafluoroethylene as a low adhesion carrier web and was dried for 5 minutes at 100°C to a dried thickness of 25 micrometers between the silver particles to provide an adhesive transfer tape of the invention. The thickness of its adhesive layer between par-ticles was about 80% of the average diameter of the particles.

The adhesive layer was transferred to the back surface of a 75-mm diameter silicon wafer by preheating the wafer on a hot plate to 200°C, positioning the adhesive over the wafer and bringing it into full contact with the wafer by means of a rubber roll. After cooling, the adhesive was trimmed around the wafer circumference, and the release liner and excess adhesive were removed. The wafer was then sawed into individual 1.3 mm×1.3 mm dice after being mounted onto a blue vinyl wafer sawing film (Semiconductor Equipment Corp. Part No. 18074). Individual dice were removed from the wafer sawing film and bonded at 250°C under a compressive force of 55 newtons to a silver layer on an alumina ceramic substrate. Electrical resistance of the bond between a silicon die and the silver layer was 0.3 ohm as measured by the 4-probe resistance method. The thermal conductivity was 0.017 watts/cm°C. The force required to shear this bond was 46 newtons at ordinary room temperature; 6.7 newtons at 100°C; and 1.0 newton at 200°C.

Example 2

An acrylic polymer having a weight-averaged $T_g$ of 28°C was selected and prepared as in Example 1 from the following:

|  | Parts |
| --- | --- |
| methyl methacrylate | 6.10 |
| methyl acrylate | 22.00 |
| acrylamide | 1.65 |
| silane | 0.30 |
| "Vazo" 64 catalyst | 0.05 |
| ethyl acetate | 70.00 |

To this was added 9 parts of spherical silver particles which had been sieved, selecting particles which passed through a Tyler sieve of 200-mesh (75-micrometer openings) and were held on 325-mesh (45-micrometer openings) followed by flattening in a 3-roll paint mill to a thickness of approximately 40 micrometers. This was knife-coated onto a silicone-surface biaxially-oriented polyetheylene terephthalate film and dried 10 minutes at 80°C to a thickness of about 20 micrometers between the silver particles. The thickness of the adhesive layer between particles was about one-half the average thickness of the particles.

The adhesive layer of this transfer tape was transferred to the back of a silicon wafer as in Example 1 except at 150°C. After being sawed into individual dice as in Example 1, each die was bonded onto a silver-coated alumina substrate at 180°C under a compressive force of 67 newtons. The 4-probe bond resistance measurement indicated a bond resistance of 2.4 ohms between the die and the silver coating. The force required to shear this bond was 17 newtons at ordinary room temperature.

Example 3

To another portion of the polymer solution of Example 1 was added 8.25 parts spherical silver particles sieved in the same manner as Example 1. This was knife-coated into a flexible polytetrafluoroethylene film and dried 5 minutes at 100°C. Between particles the dried adhesive layer was 15 micrometers thick or approximately 50% of the average particle diameter. The adhesive layer was transferred at 200°C to the back of a silicon wafer which was then sawed into 1.3 mm×1.3 mm dice in the same manner as in Example 1. The resistance between a die and the silver layer of the substrate to which it was bonded at 250°C was 0.6 ohm measured as in Example 1. The force required to shear the bond was 39 newtons at ordinary room temperature.

Example 4

To another portion of the polymer solution of Example 1 was added 16.5 parts of the flattened silver particles used in Example 2. This was knife-coated onto a polytetrafluoroethylene film carrier web and dried 10 minutes at 100°C. The adhesive thickness between particles was about 40 micrometers or 75% of the average particle thickness. This adhesive was transferred to the back of a silicon wafer which was then sawed into 1.3 mm×1.3 mm dice in the same manner as in Example 1. When bonded at 250°C onto a silver-coated alumina substrate, the bond had a resistance of 0.5 ohm and was sheared at a force of 40 newtons at ordinary room temperature.

**Claims**

1. Adhesive transfer tape comprising a flexible, low-adhesion carrier web to which is lightly adhered a layer of adhesive containing electrically and thermally conductive particles which at the bonding temperature of the adhesive are at least as deformable as are substantially pure silver spherical particles at ordinary room temperatures, said conductive particles being of uniform thickness greater than the thickness of the adhesive between particles, and being uniformly distributed throughout the layer or preselected segments of the layer, and when said particle-containing layer is removed form the carrier web and compressed between two flat rigid plates, the particles are flattened to the thickness of the adhesive between particles, thus providing small, flat conductive areas at both surfaces of the adhesive layer.

2. Adhesive tape as defined in claim 1 wherein the average spacing between adjacent particles is no greater than about 0.5 mm.

3. Adhesive tape as defined in claim 1 wherein the particles are substantially spherical.

4. Adhesive tape as defined in claim 3 wherein the particles are silver.

5. Adhesive tape as defined in claim 1 wherein the adhesive is a heat-activatable adhesive and each of the particles is a laminated particle having a surface layer that melts and a core that does not melt at the activation temperature of the adhesive.

6. Adhesive tape as defined in claim 5 wherein the surface layer of each of the particles is a solder.

7. Adhesive tape as defined in claim 5 wherein the core is metal.

8. Adhesive tape as defined in claim 5 wherein the core is nonmetallic.

9. Adhesive tape as defined in claim 1 wherein the adhesive is a heat-activatable adhesive and each of the particles has a surface layer that does not melt and a core that melts at the activation temperature of the adhesive.

10. Adhesive tape as defined in claim 9 wherein the core is a solder.

11. Adhesive tape as defined in claim 10 wherein the surface layer of each of the particles is silver.

12. Adhesive tape as defined in claim 1 wherein the carrier web does not wrinkle when briefly exposed to 200°C.

13. Adhesive tape as defined in claim 1 wherein each of the particles is an aggregate of tiny fused granules.

14. Adhesive tape useful as a die attach adhesive comprising a flexible, low-adhesion carrier web to which is lightly adhered a layer of adhesive containing electrically and thermally conductive elements which have protuberances at each surface of the layer that are closely spaced and uniformly distributed throughout the layer, which protuberances at the bonding temperature of the adhesive are at least as deformable as are substantially pure silver spherical particles at ordinary room temperatures.

15. Adhesive tape as defined in claim 14 wherein the elements form a woven wire screen.

16. Adhesive tape as defined in claim 14 wherein the elements form a metal foil, the thickness of which is less than half the thickness of the adhesive between protuberances.

17. Adhesive tape as defined in claim 16 wherein the metal foil has knobby protuberances from each of its surfaces.

18. Adhesive tape as defined in claim 17 wherein protuberances from one surface are aligned with protuberances from the other surface and each protuberance is sufficiently soft to be flattened when the adhesive tape is compressed.

19. Adhesive tape as defined in claim 17 wherein the protuberances are provided by drops of solder fused to the metal foil.

20. Adhesive tape as defined in claim 14 wherein the protuberances are provided by embossments of the metal foil.

21. Adhesive tape as defined in claim 1 wherein the adhesive layer comprises a polymer of at least one of alkyl acrylate and alkyl methacrylate having a weight-averaged $T_g$ of $-10°$ to 80°C.

22. Adhesive tape as defined in claim 21 wherein said polymer is a copolymer of monomers, up to 50 mol% of which is at least one copolymerizable monomer selected from acrylic acid, methacrylic acid, itaconic acid, maleic acid, maleic anhydride, amides of said acids, and N-vinyl-2-pyrrolidone.

23. Method of attaching a die to a thermally and electrically conductive substrate comprising the steps of bonding to a semiconductor wafer the adhesive layer of the tape defined in claim 1, cutting the wafer and adhesive layer into individual adhesive-bearing dies and, at the bonding temperature of the adhesive, pressing the adhesive layer of a die against said substrate under sufficient pressure to flatten the conductive particles of the tap to the thickness of the adhesive layer between particles.

24. Method as defined in claim 23 wherein the adhesive is heat-activatible and is heated to its activation temperature during the compressing.

## Patentansprüche

1. Klebstoffübertragungsband mit einem schwach klebfähigen, flexiblen Rücken, an dem eine Schicht aus einem Klebstoff leicht angeklebt ist, der elektrisch und wärmeleitende Teilchen enthält, die bei der Klebetemperatur des Klebstoffes mindestens so verformbar sind wie aus im wesentlichen reinen bilder bestehende, kugelige Teilchen bei normalen Zimmertemperaturen, wobei die leitenden Teilchen eine einheitliche Dicke haben, die größer ist als die Dicke des Klebstoffes zwischen den Teilchen, und in der ganzen Schicht oder in vorgewählten Segmenten der Schicht gleichmäßig verteilt sind, und rach der Abnahme der teilchenhaltigen Schicht von dem Rücken durch Zusammendrücken dieser Schicht zwischen zwei flachen, starren Platten die Teilchen auf die Dicke des Klebstoffes zwischen den Teilchen flachgedrückt werden, so daß auf beiden Oberflächen der Klebstoffschicht kleine, flache, leitende Flächen vorhanden sind.

2. Klebeband nach Anspruch 1, dadurch gekennzeichnet, daß der durchschnittliche Abstand zwischen einander benachbarten Teilchen nicht grüber ist als etwa 0,5 mm.

3. Klebeband nach Anspruch 1, dadurch gekennzeichnet, daß die Teilchen im wesentlichen kugelig sind.

4. Klebeband nach Anspruch 3, dadurch gekennzeichnet, daß die Teilchen aus Silber bestehen.

5. Klebeband nach Anspruch 1, dadurch gekennzeichnet, daß der Klebstoff ein wärmeaktivierbarer Klebstoff ist und daß jedes der Teilchen ein geschichtetes Teilchen ist, das eine Oberflächenschicht besitzt, die bei der Aktivierungstemperatur des Klebstoffes schmitzt, und einen Kern, der bei dieser Temperatur nicht schmilzt.

6. Klebeband nach Anspruch 5, dadurch gekennzeichnet, daß die Oberflächenschicht jedes der Teilchen aus einem Lot besteht.

7. Klebeband nach Anspruch 5, dadurch gekennzeichnet, daß der Kern aus Metall besteht.

8. Klebeband nach Anspruch 5, dadurch gekennzeichnet, daß der Kern nichtmetallisch ist.

9. Klebeband nach Anspruch 1, dadurch gekennzeichnet, daß der Klebstoff ein wärmeaktivierbarer Klebstoff ist und jedes der Teilchen eine Oberflächenschicht besitzt, die bei der Aktivierungstemperatur des Klebstoffes nicht schmilzt, und einen Kern, der bei dieser Temperatur schmilzt.

10. Klebeband nach Anspruch 9, dadurch gekennzeichnet, daß der Kern aus einem Lot besteht.

11. Klebeband nach Anspruch 10, dadurch gekennzeichnet, daß die Oberflächenschicht jedes der Teilchen aus Silber besteht.

12. Klebeband nach Anspruch 1, dadurch gekennzeichnet, daß der Rücken bei kurzzeitiger Einwirkung einer Temperatur von 200°C keine Falten bildet.

13. Klebeband nach Anspruch 1, dadurch gekennzeichnet, daß jedes der Teilchen ein Aggregat aus winzigen geschmolzenen Granülen ist.

14. Klebeband, das als Klebstoff zum Befestigen von Plättchen verwendbar ist, mit einem schwach klebfähigen, flesiblen Rücken, an dem eine aus einem Klebstoff bestehende Schicht leicht angeklebt ist, die elektrisch und wärmeleitende Elemente enthält, die auf jeder Oberfläche der Schicht Erhöhungen besitzen, die in kleinen Abständen voneinander angeordnet und in der ganzen Schicht gleichmäßig verteilt sind und bei der Klebetemperatur des Klebstoffes mindestens so verformbar sind wie aus im wesentlichen reinem Silber bestehende Teilchen bei gewöhnlichen Zimmertemperaturen.

15. Klebeband nach Anspruch 14, dadurch gekennzeichnet, daß die Elemente ein aus Draht gewebtes Gitter bilden.

16. Klebeband nach Anspruch 14, dadurch gekennzeichnet, daß die Elemente eine Metallfolie bilden, deren Dicke kleiner ist als die Hälfte der Dicke des Klebstoffes Zwischen den Erhöhungen.

17. Klebeband nach Anspruch 16, dadurch gekennzeichnet, daß die Metallfolie auf jeder ihrer Oberflächen noppenartige Erhöhungen besitzt.

18. Klebeband nach Anspruch 17, dadurch gekennzeichnet, daß auf einer Oberfläche vorgesehene Erhöhungen mit auf der anderen Oberfläche vorgesehenen Erhöhungen fluchten und jede Erhöhung so weich ist, daß sie bei einem Zusammendrücken des Klebebandes flachgedrückt wird.

19. Klebeband nach Anspruch 17, dadurch gekennzeichnet, daß die Erhöhungen von an die Metallfolie angeschmolzenen Lottropfen gebildet werden.

20. Klebeband nach Anspruch 14, dadurch gekennzeichnet, daß die Erhöhungen von geprägten Buckeln der Metallfolie gebildet werden.

21. Klebeband nach Anspruch 1, dadurch gekennzeichnet, daß die Klebstoffschicht mindestens teilweise aus einem Polymer besteht, das aus Alkylacrylat und/oder Alkylmethacrylat mit einer gewichtsdruchschnittlichen Glasübergangstemperatur zwischen −10 und 80°C besteht.

22. Klebeband nach Anspruch 21, dadurch gekennzeichnet, daß das Polymer ein Copolymer aus Monomeren besteht, die zu bis zu 50 Mol.%

aus mindestens einem copolymerisierbaren Monomer bestehen, das aus Acrylsäure, Methacrylsäure, Itaconsäure, Maleinsäure, Maleinsäureanhydrid, den Amiden der genannten Säuren und N-Vinyl-2-pyrrolidon ausgewählt ist.

23. Verfahren zum Befestigen eines Plättchens an einem wärme- und elektrisch leitenden Substrat, mit folgenden Schritten: die Klebstoffschicht des Bandes nach Anspruch 1 wird mit einer Halbleiterscheibe verklebt, die Scheibe und die Klebstoffschicht werden in einzelne, mit Klebstoff versehene Plättchen zerschnitten, und bei der Klebetemperatur des Klebstoffes wird die Klebstoffschicht eines Plättchens gegen das Substrat unter einem Druck gedrückt, der genügt, um die leitenden Teilchen auf die Dicke der Klebstoffschicht zwischen den Teilchen flachzudrücken.

24. Verfahren nach Anspruch 23, dadurch gekennzeichnet, daß der Klebstoff wärmeaktivierbar ist und beim Zusammendrücken auf seine Aktivierungstemperatur erwärmt wird.

**Revendications**

1. Ruban de transfert d'adhésif, comprenant une bande porteuse flexible, de faible adhérence, à laquelle adhère légèrement une couche d'adhesif, contenant des particules conductrices de l'électricité et de la chaleur, qui, à la température de liaison de l'adhésif, sont au moins aussi déformables que des particules sphériques essentiellement pures d'argent aux températures ambiantes ordinaires, ces particules conductrices étant d'une épaisseur uniforme supérieure à l'épaisseur de l'adhésif existant entre les particules, et étant uniformément réparties dans toute la couche ou dans des segments préalablement choisis de celle-ci, et, lorsque la couche contenant des particules est enlevée de la bande porteuse et comprimée entre deux plaques rigides planes, les particules sont aplaties à l'épaisseur de l'adhésif existant entre ces particules, ce qui donne ainsi de petites zones conductrices planes suivant les deux surfaces de la couches d'adhésif.

2. Ruban à adhésif suivant la revendication 1, caractérisé en ce que l'écartement moyen entre les particules adjacentes n'est pas supérieur à environ 0,5 mm.

3. Ruban à adhésif suivant la revendication 1, caractérisé en ce que les particules sont essentiellement sphériques.

4. Ruban à adhésif suivant la revendication 3, caractérisé en ce que les particules sont des particules d'argent.

5. Ruban à adhésif suivant la revendication 1, caractérisé en ce que l'adhésif est un adhésif pouvant être activé à la chaleur et en ce que chacune des particules est une particule stratifiée comportant une couche superficielle qui fond et un noyau qui ne fond pas à la température d'activation de l'adhésif.

6. Ruban à adhésif suivant la revendication 5, caractérisé en ce que la couche superficielle de chacune des particules est faite d'une soudure.

7. Ruban à adhésif suivant la revendication 5, caractérisé en ce que le noyau est en métal.

8. Ruban à adhésif suivant la revendication 5, caractérisé en ce que le noyau est non métallique.

9. Ruban à adhésif suivant la revendication 1, caractérisé en ce que l'adhésif est un adhésif pouvant être activé à la chaleur, et en ce que .chacune des particules comporte une couche superficielle qui ne fond pas et un noyau qui fond à la température de l'adhésif.

10. Ruban à adhésif suivant la revendication 9, caractérisé en ce que le noyau est formé d'une soudure.

11. Ruban à adhésif suivant la revendication 10, caractérisé en ce que la couche superficielle de chacune des particules est faite d'argent.

12. Ruban à adhésif suivant la revendication 1, caractérisé en ce que le bande porteuse ne se plisse pas lorsqu'elle est exposée brièvement à 200°C.

13. Ruban à adhésif suivant la revendication 1, caractérisé en ce que chacune des particules est constituée par un agglomérat de granules ténus fusionnés.

14. Ruban à adhésif intéressant comme adhésif de fixation pour une tranche de matière semi-conductrice, comprenant une bande porteuse flexible, de faible adhérence, à laquelle adhère légèrement une couche d'adhésif contenant des éléments conducteurs de l'électricité et de la chaleur qui présentent des protuberances à chaque surface de la couche susdite et qui sont ètroitement espacés et uniformément répartis dans la totalité de la couche, ces protubérances, aux températures de liaison de l'adhésif, étant au moins aussi déformables que des particules sphériques essentiellement pures d'argent aux températures ambiantes ordinaires.

15. Ruban à adhésif suivant la revendication 14, caractérisé en ce que les éléments formant un treillis métallique tissé.

16. Ruban à adhésif suivant la revendication 14, caractérisé en ce que les éléments formant une feuille métallique, dont l'épaisseur est inférieure à la moitié de l'épaisseur de l'adhésif compris entre les protubérances.

17. Ruban à adhésif suivant la revendication 16, caractérisé en ce que la feuille métallique comporte des protuberances en forme de bosses suivant chacune des ses surfaces.

18. Ruban à adhésif suivant la revendication 17, caractérisé en ce que les protubérances d'une surface sont en alignement avec les protubérances de l'autre surface, et en ce que chaque protubérance est suffisament molle pour être aplatie lorsque le ruban à adhésif est comprimé.

19. Ruban à adhésif suivant la revendication 17, caractérisé en ce que les protubérances sont formées par des gouttes de soudure fusionnées à la feuille métallique.

20. Ruban à adhésif suivant la revendication 14, caractérisé en ce que les protubérances sont formées par des bosselages de la feuille métallique.

21. Ruban à adhésif suivant la revendication 1, caractérisé en ce que la couche d'adhésif comprend un polymère d'au moins un composé formé par un acrylate d'alkyle et un méthacrylate d'alkyle, ayant une valeur $T_g$ moyenne en poids de −10° à 80°C.

22. Ruban à adhésif suivant la revendication 21, caractérisé en ce que le polymère susdit est un copolymère de monomères, dont jusqu'à 50 moles % sont constitués par au moins un monomère copolymérisable cloisi parmi l'acide acrylique, l'acide méthacrylique, l'acide itaconique, l'acide maléique, l'anhydride maléique, les amides de ces acides, et la N-vinyl-2-pyrrolidone.

23. Procédé de fixation d'une tranche de matière semi-conductrice à un support conducteur de la chaleur et de l'électricité, comprenant les phases de liaison à une galette à semiconducteurs, de la couche d'adhésif du ruban suivant la revendication 1, de découpage de la galette et de la couche d'adhésif en tranches individuelles portant de l'adhésif, et, à la température de liaison de l'adhésif, de pression de la couche d'adhésif d'une tranche contre le support susdit sous une pression suiffisante pour aplatir les particules conductrices du ruban à l'épaisseur de la couche d'adhésif existant entre les particules.

24. Procédé suivant la revendication 23, caractérisé en ce que l'adhésif est un adhésif pouvant être activé à la chaleur et est chauffé à sa température d'activation durant la compression.

Fig. 1

Fig. 2

Fig. 3